(19) Europäisches Patentamt
European Patent Office
Office européen des brevets

(11) Numéro de publication: **0 341 121 A1**

(12) **DEMANDE DE BREVET EUROPEEN**

(21) Numéro de dépôt: **89401128.7**

(22) Date de dépôt: **21.04.89**

(51) Int. Cl.⁴: **H 01 L 31/02**
H 01 L 31/16, H 01 L 27/14

(30) Priorité: **03.05.88 FR 8805903**

(43) Date de publication de la demande:
**08.11.89 Bulletin 89/45**

(84) Etats contractants désignés: **DE FR GB NL**

(71) Demandeur: **THOMSON-CSF**
**51, Esplanade du Général de Gaulle**
**F-92800 Puteaux (FR)**

(72) Inventeur: **Henry, Yves**
**THOMSON-CSF SCPI Cedex 67**
**F-92045 Paris La Defense (FR)**

(74) Mandataire: **Guérin, Michel et al**
**THOMSON-CSF SCPI**
**F-92045 PARIS LA DEFENSE CEDEX 67 (FR)**

(54) **Détecteur d'images radiologiques.**

(57) L'invention concerne un détecteur d'images radiologiques (10) du type formé par une matrice (1) d'éléments photosensibles (D) associée à une source de lumière (12) permettant d'effectuer une remise à niveau des tensions aux bornes des éléments photosensibles (D) ; la source de lumière (12) et la matrice photosensible (1) étant liées l'une à l'autre de manière à conférer au détecteur d'images (10) une épaisseur particulièrement faible.

A cette fin, la source de lumière (12) comprend un empilement de couches semiconductrices (15, 16, 17) constituant au moins une diode électroluminescente (DEL) ayant pour support un substrat (11) de la matrice (1).

FIG_2-a

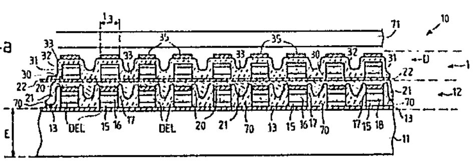

EP 0 341 121 A1

**Description**

## DETECTEUR D'IMAGES RADIOLOGIQUES

L'invention concerne un détecteur d'images radiologiques du type comportant un arrangement matriciel d' éléments photosensibles, et concerne particulièrement des moyens pour produire une lumière destinée à réaliser une remise à niveau des tensions aux bornes des éléments photosensibles.

Les techniques qui permettent d'effectuer des dépôts en couches minces, de silicium amorphe notamment, sont maintenant bien maîtrisées, et permettent de réaliser des matrices d'éléments photosensibles de grande dimension (40 cm x 40 cm) et de haute résolution, et qui peuvent donc constituer des détecteurs d'images de type numérique avantageusement applicables à la radiologie.

De manière classique, les matrices photosensibles comportent un réseau de conducteurs en ligne et un réseau de conducteurs en colonne. A chaque croisement d'un conducteur en ligne et d'un conducteur en colonne, est disposé un montage photosensible, appelé point photosensible. Les points photosensibles sont ainsi organisés également en ligne et en colonne. Chaque point photosensible est connecté entre un conducteur ligne et un conducteur colonne : en fait, à chaque conducteur ligne sont connectés autant de points photosensibles qu'il y a de colonnes de ces derniers, et à chaque conducteur en colonne sont connectés autant de points photosensibles qu'il y a de lignes de ces derniers.

Chaque point photosensible comporte au moins un élément photosensible tels que photodiode, phototransistor, photoconducteur, sensible aux photons lumineux visibles. Ces photons lumineux sont convertis en charge électrique, et cette charge électrique est accumulée dans une capacité électrique formant une capacité de stockage, constituée soit par la capacité de l'élément photosensible lui-même, soit par une capacité annexe associée. Un dispositif de lecture permet d'interroger l'état électrique de la capacité de stockage, et de convoyer la charge électrique qui constitue le signal vers un amplificateur de signal.

Un exemple de matrice photosensible est donné dans un brevet français n° 86 00656 publié sous le n° 2 579 319 qui décrit le fonctionnement détaillé d'une matrice photosensible ainsi que le procédé de lecture approprié ; chaque point photosensible de cette matrice est constitué par une photodiode en série avec une capacité.

Un autre brevet français n° 86 00716 publié sous le n° 2 593 343 se rapporte à une matrice ayant un réseau de points photosensibles constitués chacun par une photodiode et une capacité en série, comme ci-dessus mentionné, et ce brevet décrit un procédé de fabrication d'une telle matrice photosensible, ainsi qu'un procédé de lecture de cette matrice et une application de cette matrice à la prise de vues d'images radiologiques. En vue de capter des images radiologiques, la structure présentée comporte un écran ou panneau scintillateur qui est soumis à un rayonnement X. En réponse à ce rayonnement X , l'écran scintillateur émet un rayonnement en lumière visible auxquels sont sensibles les éléments photosensibles.

Le fonctionnement des éléments photosensibles tel que décrit par exemple dans les deux demandes de brevet ci-dessus citées, peut exiger une phase de restauration du potentiel aux bornes de l'élément photosensible, cette restauration de potentiel étant appelée phase de remise à niveau des tensions ou RAN dans les demandes de brevet ci-dessus citées. Cette phase de remise à niveau de type optique, peut s'effectuer soit par un éclairement uniforme calibré, de durée donnée, ou permanent qui produit un signal peu bruyant qui se superpose au signal à lire, soit par un flash lumineux intense.

Pour réaliser une remise à niveau de type optique telle que ci-dessus mentionnée, il est connu d'utiliser un réseau de diodes électroluminescentes du commerce, formant chacune de manière classique un élément indépendant, et qui sont montées sur un panneau de sorte à constituer un panneau lumineux offrant une surface émettrice de lumière ayant sensiblement les mêmes dimensions que la matrice d'éléments photosensibles ou panneau photosensible ; le panneau lumineux étant appliqué contre le panneau photosensible, cet ensemble constituant un détecteur d'images de type numérisé.

Un premier inconvénient de ce détecteur d'images numérisé est qu'il présente une épaisseur trop importante pour être interchangeable avec une cassette à film utilisée actuellement sur les appareils de radiographie médicale ; ceci étant dû à la trop grande épaisseur du panneau lumineux. Un autre inconvénient réside dans la complexité du système mécanique de support et d'assemblage de l'ensemble panneau lumineux-panneau photosensible.

L'un des buts de la présente invention est de permettre la réalisation d'un détecteur d'images radiologiques numérisé, du type comportant une matrice d'éléments photosensibles et des moyens destinés à effectuer une remise à niveau de type optique, tout en restant compatible, au sens de l'interchangeabilité c'est-à-dire des dimensions, avec les systèmes radiologiques classiques à film.

Selon l'invention, un détecteur d'images radiologiques, comportant, un substrat portant une matrice de points photosensibles, au moins une source de lumière, chaque point photosensible comportant au moins un élément photosensible, la source de lumière émettant une lumière destinée à réaliser une remise à niveau en tension des éléments photosensibles, est caractérisé en ce que la source de lumière comprend un empilement de couches semiconductrices déposées entre deux couches conductrices de sorte à constituer au moins une diode électroluminescente ayant pour support le substrat de la matrice d'éléments photosensibles.

D'autres caractéristiques et avantages de l'invention apparaîtront à la lecture de la description qui suit, faite à titre d'exemple non limitatif en référence aux dessins annexés parmi lesquels :

- la figure 1 montre, à titre d'exemple non limitatif, le schéma électrique d'une matrice photosensible susceptible d'être utilisée dans un détecteur d'images conforme à l'invention ;

- les figures 2a et 2b sont des coupes latérales selon deux directions orthogonales, montrant schématiquement une première forme de réalisation d'un détecteur d'images selon l'invention dans lequel est intégrée une source de lumière ;

- la figure 3 est une coupe latérale semblable à la figure 2a, qui montre schématiquement une autre forme de réalisation du détecteur d'images conforme à l'invention, et illustre une position différente de la source de lumière montrée aux figures 2a et 2b ;

- la figure 4 est une vue en coupe latérale qui illustre schématiquement une troisième forme de réalisation du détecteur d'images de l'invention.

La figure 1 montre le schéma électrique d'une matrice photosensible 1, ce schéma électrique étant en lui-même classique. En effet, la matrice 1 comprend une pluralité de points photosensibles P1, P2, ..., P9 qui sont disposés en ligne et en colonne. Dans l'exemple non limitatif décrit, les points photosensibles P1 à P9 sont constitués chacun par un élément photosensible D en série avec une capacité C, selon un même montage que les points photosensibles décrits dans les brevets français n° 86 00656 et n° 86 00716 précédemment cités. Bien entendu l'invention est applicable avec d'autres types de cellules photosensibles, dès lors qu'il est nécessaire d'utiliser une source de lumière pour restaurer les tensions aux bornes des éléments photosensibles. Dans l'exemple non limitatif décrit, le nombre de points photosensibles P1 à P9 est limité à 9, selon un assemblage matriciel 3 x 3 pour simplifier la figure 1, mais dans l'esprit de l'invention cet assemblage matriciel peut avoir une capacité beaucoup plus grande, de plusieurs millions de points par exemple.

La matrice 1 comporte des conducteurs en ligne L1 à L3 et des conducteurs en colonne F1 à F3, le nombre de chaque type de ces conducteurs étant limité à trois, compte-tenu de l'exemple de la figure 1 où seulement 9 points photosensibles sont représentés.

En pratique et d'une manière en elle-même classique, les points photosensibles P1 à P9 sont formés chacun à l'intersection I d'un conducteur en ligne L1 à L3 et d'un conducteur en colonne F1 à F3. Chaque point photosensible P1 à P9 comporte une première extrémité 10 connectée à un conducteur ligne L1 à L3, et comporte une seconde extrémité 11 connectée à un conducteur colonne F1 à F3. La jonction formée entre l'élément photosensible D et la capacité C constitue une zone A où sont engendrées et stockées des charges dont la quantité est proportionnelle à l'éclairement de l'élément photosensible D. Dans l'exemple non limitatif décrit, l'élément photosensible D est une photodiode, mais il pourrait être d'un type différent.

De manière classique, la matrice 1 est partagée en surfaces élémentaires Se1, Se2, ..., Se9, pouvant être centrées chacune sur un centre de croisement ou intersection I et comportant chacune un point photosensible P1 à P9. Les surfaces élémentaires Se1 à Se9 ont des dimensions déterminées par les pas des réseaux de conducteurs en ligne et en colonne L1 à L3 et F1 à F3, lesquels pas sont symbolisés respectivement par une première et une seconde longueur l1, l2 d'un premier et d'un second côté 5,6 de ces surfaces élémentaires Se1 à Se9. Si les pas sont les mêmes, les surfaces élémentaires Se1 à Se9 ont une forme carrée, comme dans l'exemple non limitatif décrit, et dans le cas de matrice à grande capacité (plusieurs millions de points), la longueur l1, l2 d'un côté 5,6 peut être de l'ordre de 200 micromètres.

Les conducteurs en ligne L1 à L3 sont reliés à un dispositif d'adressage ligne 3, et les conducteurs en colonne F1 à F3 sont reliés à un dispositif de lecture et de multiplexage 4, de sorte à mettre en oeuvre l'un ou l'autre des procédés enseignés dans les demandes de brevets français n° 86 00656 et n° 86 00716 , en vue dans un premier temps, de permettre la création et le stockage de charges ou d'informations aux différents points A, et dans un second temps, de permettre la lecture et l'acquisition de ces informations. On rappelle que pour chaque point photosensible P1 à P9, les phases principales du fonctionnement sont les suivantes :

- (1) phase de polarisation en inverse de la photodiode ;
- (2) phase d'éclairement de la photodiode (par suite par exemple d'un flash d'un rayonnement X pour l'irradiation d'un patient, et conversion du rayonnement X en un rayonnement de longueur d'onde visible ou proche du visible) ; stockage de l'information correspondant à l'éclairement ;
- (3) phase de lecture (polarisation en direct de la photodiode) ;
- (4) phase de remise à niveau des tensions aux bornes de la photodiode, obtenue soit au moyen d'un éclairement uniforme calibré soit au moyen d'un flash lumineux intense (c'est-à-dire à l'aide d'une source de lumière).

Les figures 2a et 2b sont des coupes latérales selon deux directions orthogonales, qui montrent de manière schématique, à titre d'exemple non limitatif, une première forme de réalisation d'une structure d'un détecteur d'images 10 conforme à l'invention.

Le détecteur d'images 10 comporte une matrice 1 de points photosensibles du type montré à la figure 1 par exemple, cette matrice étant portée par un substrat 11.

Selon une caractéristique de l'invention, le détecteur 10 comporte au moins une source de lumière 12 intégrée dans la structure, c'est-à-dire ayant pour support le même substrat 11 que la matrice 1.

Dans l'exemple non limitatif de cette première version de l'invention, la source de lumière 12 est disposée entre la matrice 1 de points photosensibles et le substrat 11. Aussi le substrat 11 peut être dans ce cas en un matériau quelconque compatible avec la fonction de substrat, opaque ou non à la lumière émise par la source de lumière 12 : ainsi le substrat 11 peut être en verre et transparent, mais il

peut aussi être opaque et métallique en acier inoxydable par exemple, ce qui permet dans ce dernier cas de réduire son épaisseur E.

Dans l'exemple non limitatif de la description, la source de lumière 12 est constituée à partir d'un empilement de trois couches semiconductrices 15, 16, 17 disposées entre une couche électriquement conductrice inférieure 13 et une couche électriquement conductrice supérieure 20. Cet ensemble est destiné à former une ou plusieurs ou une pluralité de diodes électroluminescentes DEL, le nombre de diodes électroluminescentes DEL étant fonction d'une gravure éventuelle en elle-même classique de ces couches. Dans l'exemple non limitatif décrit, la couche inférieure conductrice 13 est constituée par exemple en oxyde d'indium-étain (ITO) et elle peut être gravée de sorte à obtenir un réseau d'électrodes colonne 13. Sur la couche conductrice inférieure ou électrode colonne 13 est ensuite déposé l'empilement des trois couches semiconductrices 15, 16, 17 qui forment par exemple une structure de type NIP destinée à constituer la matrice des diodes électroluminescentes DEL précédemment mentionnées, et dont le principe de fonctionnement est connu par un article de Yoshihito Hamakawa et al. publié dans Japanese Journal Of Applied Physics, volume 24, n° 10, Octobre 1985, page 806 ; et qui est connu d'autre part par MRS Meeting Los-Angeles 22-24 Avril 1987.

Comme il a été dit ci-dessus, la ou les diodes électroluminescentes sont constituées par trois couches semiconductrices superposées 15, 16, 17 formant une structure NIP en carbure de silicium amorphe SiC, obtenue par une méthode de décomposition chimique en phase gazeuse (CVD), activée par un plasma : la première couche 15 est une couche en carbure de silicium amorphe hydrogéné dopé avec une impureté de type N, de phosphore par exemple, cette première couche 15 étant obtenue avec une concentration de gaz actif telle que par exemple $CH_4/(SiH_4 + CH_4) = 0,25$ ; la seconde couche 16 est une couche en carbure de silicium amorphe hydrogéné intrinsèque obtenue avec une concentration de gaz actif telle que par exemple $CH_4/ (SiH_4 + CH_4) = 0,5$ ; la troisième couche 17 est une couche en carbure de silicium amorphe hydrogéné dopé avec une impureté de type P, du bore par exemple, cette troisième couche étant obtenue avec une concentration de gaz actif telle que par exemple

$CH_4/(SiH_4 + CH_4) = 0,25$.

Ces trois couches 15, 16, 17 peuvent ensuite être photogravées de manière par exemple à laisser subsister une série de carrés ou ilôts destinés à constituer les diodes électroluminescentes DEL, et formant une matrice dont les éléments sont alignés sur les colonnes 13. Dans le cas d'une telle gravure, on dépose ensuite sur ces trois couches 15, 16, 17, une couche isolante 70, transparente, en nitrure de silicium par exemple, comme représenté à la figure 2a. Des ouvertures sont réalisées dans cette couche isolante 70 au-dessus de la troisième couche semiconductrice 17, de sorte à mettre en contact les diodes électroluminescentes DEL avec la couche conductrice supérieure 20. On dépose ensuite la couche conductrice supérieure 20, transparente, constituée par exemple d'un oxyde d'indium-étain (ITO) ; cette couche supérieure conductrice 20 pouvant être gravée de sorte à constituer un réseau d'électrodes ou conducteurs ligne perpendiculaire aux électrodes ou conducteurs colonnes 13. Il est à noter qu'il est possible de conférer aux diodes électroluminescentes DEL des formes de bandes parallèles aux électrodes lignes 20 : dans ce cas les trois couches semiconductrices 15, 16, 17 sont gravées en même temps que les éleectrodes lignes 20 formées par la couche conductrice supérieure 20, et cette dernière est déposée directement sur la couche 17, comme montré à la figure 2b, sans qu'il soit nécessaire de déposer la couche isolante 70, et sans qu'il soit nécessaire éventuellement de graver la couche conductrice inférieure 13.

Cet ensemble est ensuite recouvert par une couche 21 isolante et transparente à la lumière, en résine polymide par exemple de quelques micromètres d'épaisseur tel que par exemple le produit vendu sous la référence Pi2555 par la Société DUPONT de NEMOURS.

La source de lumière 12 ayant ainsi été réalisée, on trouve ensuite au-dessus de cette dernière la matrice 1 qui est constituée d'une manière en elle-même classique, comme expliqué ci-après : une couche 22 d'un matériau électriquement conducteur est déposée sur la couche isolante 21 : cette couche 22 électriquement conductrice est constituée par exemple par de l'oxyde d'indium-étain (ITO), et elle est gravée de sorte à constituer un nombre n de conducteurs en colonne F1, F2, F3,..., Fn. On trouve ensuite les éléments photosensibles D, chaque élément photosensible étant constitué par exemple par une diode PIN (jonction PN avec partie centrale intrinsèque) ; les diodes D sont formées par le dépôt de trois couches successives 30, 31, 32 : la première couche 30 est une couche de silicium amorphe hydrogéné dopé avec une impureté de type P, du bore par exemple ; la couche suivante 31 est une couche de silicium amorphe hydrogéné intrinsèque ; enfin la troisième couche 32 est une couche de silicium amorphe hydrogéné dopé avec une impureté de type N, de phosphore par exemple. Ces trois dernières couches 30, 31, 32 sont gravées selon un motif d'ilôts, de manière à constituer les éléments photosensibles ou diodes D ; les ilôts ont par exemple une forme carrée dont les côtés ont une même dimension qu'une largeur l3 des conducteurs colonnes F1, F2, F3, Fn, cette largeur l3 des conducteurs colonnes étant elle-même dans l'exemple non limitatif décrit, légèrement inférieure à la dimension l1 d'un côté d'une surface élémentaire Se1 à Se9 (représentée à la figure 1). Au-dessus de cette troisième couche 32 appartenant aux photodiodes D, on trouve une couche isolante 33 destinée à former le diélectrique des capacités C (montré sur la figure 1) qui sont en série avec les éléments photosensibles D ; la couche 33 diélectrique étant transparente, constituée par exemple en nitrure de silicium.

La couche diélectrique 33 est recouverte par une couche conductrice supérieure 35 transparente également (constituée par exemple en oxyde d'indium-étain), et qui est gravée pour former un nombre n′ de conducteurs en ligne L1, L2, L3 ,..., Ln′ ; ceux-ci ayant une même largeur que les conducteurs en colonne F1 à Fn.

Au-dessus de la couche conductrice supérieure 35 à partir de laquelle sont formés les conducteurs en ligne L1, L2, L3, Ln′, est placée une couche 71 d'une substance scintillatrice, de l'oxysulfure de gadolinium par exemple qui émet une lumière visible en réponse à un rayonnement X incident. La couche scintillatrice 71 peut être constituée par exemple, par une poudre d'oxysulfure de gadolinium noyée dans une résine thermodurcissable, de manière à constituer une feuille, cette feuille ayant une épaisseur comprise entre 100 et 400 micromètres, et qui peut être par exemple collée ou pressée sur la surface supérieure de la matrice 1 à l'opposé du substrat 11.

Dans l'exemple non limitatif décrit, la gravure de la source de lumière 12 est telle qu'une pluralité de diodes électroluminescentes DEL sont constituées de sorte à former chacune une bande électroluminescente, et ces bandes sont indexées sur les lignes de photodiodes D, c'est-à-dire qu'elles ont, parallèlement à la largeur l3 des conducteurs en ligne L1 à L3, sensiblement une même largeur que ces derniers ; ces bandes électroluminescentes DEL ayant une longueur (partiellement visible sur la figure 2b) sensiblement égale à la longueur des lignes formées par les photodiodes D. Ainsi pour un détecteur d'images 10 formant un panneau de 20 cm x 20 cm , les bandes électroluminescentes DEL ont une longueur de 20 cm (correspondant à 1000 diodes photosensibles D) et une largeur de 200 micromètres (correspondant à une photodiode D). Il est alors possible de faire fonctionner la source de lumière 12 en vue de réaliser une remise à niveau des photodiodes D ligne par ligne, en appliquant les tensions nécessaires au fonctionnement des diodes électroluminescentes DEL, par les électrodes ligne 20 de la source de la lumière 12, dans l'ordre désiré, à l'aide de moyens en eux-mêmes classiques (non représentés). Dans ce cas la source de lumière 12 comprendrait une matrice de 1000 bandes électroluminescentes DEL.

Bien entendu d'autres surfaces de diodes électroluminescentes DEL sont utilisables, allant de la diode DEL élémentaire ayant une même dimension qu'une photodiode D, à des diodes électroluminescentes DEL de plusieurs $cm^2$ de surface, permettant par exemple un fonctionnement balayage ligne par ligne comme ci-dessus expliqué, ou ayant une surface de forme différente, et pouvant aller jusqu'à la réalisation et l'utilisation d'une diode électroluminescente DEL unique, de surface totale égale à celle du panneau détecteur (par exemple 20 cm x 20 cm) ; l'avantage étant dans ce dernier cas de diminuer le nombre de connexions et d'éviter la gravure. Comme il est indiqué dans les articles ci-dessus cités, relatifs au fonctionnement de ces diodes électroluminescentes DEL la quantité de lumière émise par une diode électroluminescente DEL dépend du courant qui est injecté. Dans l'exemple de diodes électroluminescentes DEL précédemment décrit, ces dernières émettent dans le rouge ; mais la longueur d'onde peut être modifiée : par exemple, en augmentant la teneur en carbone de la couche intrinsèque 16 en carbure de silicium amorphe (c'est-à-dire

$$\frac{CH_4}{SiH_4 + CH_4} > 0,5),$$

on diminue la longueur d'onde.

Avec des diodes électroluminescentes DEL selon l'invention, la quantité de lumière émise qui est nécessaire pour réaliser la remise à niveau en tension des éléments photosensibles D est émise pour un courant de l'ordre de 50 mA par $cm^2$ de surface de la diode électroluminescente DEL : de sorte qu'un fonctionnement du type balayage ligne par ligne exige un courant de l'ordre de 20 mA, et qu'une diode électroluminescente unique ayant la surface totale du panneau photosensible exige un courant de l'ordre de 20 ampères, correspondant à une puissance dissipée de l'ordre de 100 Watts.

Les diodes électroluminescentes DEL sont alimentées dans le sens direct, c'est-à-dire que la tension d'alimentation de ces diodes électroluminescentes est appliquée de sorte que la polarité positive V+ est appliquée aux zones dopées P (couche 17), et que la polarité négative V- est appliquée aux zones dopées N (couche 15), c'est-à-dire que la polarité positive V+ de l'alimentation est appliquée à la couche électriquement conductrice supérieure 20 susceptible d'être gravée pour constituer des électrodes de ligne, et que la polarité négative V- est appliquée à la couche conductrice inférieure 13 susceptible d'être gravée pour constituer des électrodes colonne. Il en résulte que la lumière produite par les diodes électroluminescentes DEL est émise par la zone dopée P de ces dernières, c'est-à-dire par la couche 17, en direction des photodiodes D.

La figure 3 montre le détecteur d'images 10 par une vue semblable à celle de la figure 2a, et illustre une version de l'invention dans laquelle le détecteur d'images 10 comporte un écran scintillateur 40 disposé entre la matrice photosensible 1 et le substrat 11 ; le détecteur d'images 10 pouvant comporter ou non la couche scintillatrice supérieure 71 montrée à la figure 2a, la présence simultanée de deux écrans scintillateurs pouvant être intéressante notamment dans le cas d'une détection d'images radiologiques en bi-énergie.

Le scintillateur inférieur 40 peut être disposé sur le substrat 11 par une méthode telle que consistant, par exemple, à prendre une feuille scintillatrice classique et à la coller sur le substrat 11 avec une colle compatible avec les températures de traitement qui seront utilisées dans les phases suivantes. La feuille est par exemple constituée par une résine thermodurcissable dans laquelle on a noyé une poudre scintillatrice telle que de l'oxysulfure de gadolinium. La feuille peut aussi être réalisée en une résine époxy si les températures de traitements ultérieurs sont suffisamment basses. Cette méthode s'applique notamment dans le cas où la méthode de

dépôt utilisée est du type CVD, activée par une excitation lumineuse dans l'ultraviolet, et quand les températures atteintes ne dépassent pas environ 150° C. Bien entendu, si les températures de traitements ultérieurs sont supérieures à 150° C, le liant utilisé pour constituer le scintillateur est d'une nature inorganique, et le scintillateur peut être déposé par sédimentation suivant une méthode en elle-même classique.

Après dépôt et traitement de la couche scintillatrice 40, on dépose une couche isolante intermédiaire 41 qui a pour fonction notamment de planariser la surface supérieure de la couche 40, et de faire une barrière à une diffusion d'impuretés entre la couche scintillatrice 40 et la source de lumière 12. La couche isolante intermédiaire 41 peut être en polymide du type précédemment cité ; elle est déposée par centrifugation par exemple, après quoi elle est complètement polymérisée avec un recuit à 150° C durant une heure ; son épaisseur est d'environ 2 à 10 micromètres. On réalise ensuite au-dessus de cette couche isolante intermédiaire 41, la source de lumière 12 et la matrice photosensible 1 d'une même manière que dans l'exemple précédent.

Il est à noter que dans l'exemple non limitatif représenté à la figure 3, la source de lumière 12 est illustrée par une unique diode électroluminescente DEL, c'est-à-dire qu'aucune gravure n'a été réalisée dans les couches 13, 15, 16, 17, 20 qui constituent cette dernière.

La figure 4 illustre le détecteur d'images 10 selon une vue semblable à celle de la figure 4, à la différence que dans cette version la source de lumière 12 est formée sur le substrat 11, sur une face 45 de ce dernier opposée à la matrice photosensible 1. Dans cette version de l'invention le substrat 11 est obligatoirement transparent, en verre par exemple. La matrice photosensible 1 est formée d'une même manière que dans les exemples précédents, mais directement sur le substrat 11.

La source de lumière 12 comporte comme dans les exemples précédents deux couches électriquement conductrices 13, 20 entre lesquelles sont déposées les couches semiconductrices 15, 16, 17, de sorte à constituer au moins une diode électroluminescente DEL. A cet effet, on dépose sur la face 45 du substrat 11 la couche électriquement conductrice 20 précédemment citée comme susceptible d'être gravée pour constituer des électrodes colonne. On dépose ensuite sur cette couche électriquement conductrice 20 gravée ou non, la couche 17 en carbure de silicium amorphe hydrogéné dopé avec une impureté de type P ; puis on dépose sur cette couche 17 dopée P, la couche 16 en carbure de silicium amorphe intrinsèque ; puis on dépose sur cette couche 16 formant la zone intrinsèque, la couche 15 en carbure de silicium amorphe hydrogéné dopé avec une impureté de type N. On dépose ensuite la couche 13 électriquement conductrice précédemment mentionnée comme susceptible d'être gravée pour constituer des électrodes colonnes ; dans ce cas il est avantageux de réaliser cette couche 13 conductrice en un métal, en tungstène ou en molybdène par exemple, de sorte que cette couche conductrice 13 constitue en outre un réflecteur permettant d'éviter des pertes de lumière.

Comme dans les exemples précédents, la source de lumière 12 peut être constituée par une diode électroluminescente DEL unique, ou bien à l'aide des opérations de gravure, elle peut être formée d'une pluralité de diodes électroluminescentes ; l'alimentation en courant se faisant d'une même manière que dans les exemples précédents.

Il est à noter que la source de lumière 12 pourrait également être intégrée dans la structure, mais placée de l'autre côté de la matrice photosensible 1, à l'opposé du substrat 11, c'est-à-dire du côté de la couche 32 dopée N de la matrice photosensible 1 : dans ce dernier cas (non représenté) la ou les diodes électroluminescentes qui constitueraient la source de lumière 12 devraient être réalisées à partir d'une structure de type PIN de sorte que l'émission de lumière soit orientée vers les éléments photosensibles D.

## Revendications

1. Détecteur d'images radiologiques, comportant une matrice (1) de points photosensibles (P1 à P9) formée sur un substrat (11), au moins une source de lumière (12), les points photosensibles (P1 à P9) comportant chacun au moins un élément photosensible (D), la source de lumière (12) produisant une lumière destinée à réaliser une remise à niveau en tension des éléments photosensibles (D), caractérisé en ce que la source de lumière (12) comprend un empilement de couches semiconductrices (15, 16, 17) formées entre deux couches électriquement conductrices (13, 20) de sorte à constituer au moins une diode électroluminescente (DEL) ayant pour substrat le substrat (11) de la matrice (1) de points photosensibles.

2. Détecteur d'images radiologiques selon la revendication 1, caractérisé en ce que les couches semiconductrices (15, 16, 17) comprennent une couche (16) en carbure de silicium amorphe intrinsèque disposée entre une couche (15) semiconductrice dopée avec une impureté de type N et une couche (17) semiconductrice dopée avec une impureté de type P.

3. Détecteur d'images radiologiques selon l'une des revendications précédentes, caractérisé en ce que la source de lumière (12) est constituée par une diode électroluminescente (DEL) ayant sensiblement une même surface que la matrice (1) de points photosensibles.

4. Détecteur d'images radiologiques selon l'une des revendications 1 ou 2, caractérisé en ce que la source de lumière (12) est constituée par une pluralité de diodes électroluminescentes (DEL).

5. Détecteur d'images radiologiques selon la revendication 4, les éléments photosensibles (D) étant disposés selon des lignes (L1 à L3), caractérisé en ce que les diodes électroluminescentes (DEL) sont formées selon des bandes ayant sensiblement les mêmes dimensions que les lignes (L1 à L3) et qui sont indexées sur ces dernières.

6. Détecteur d'images radiologiques selon l'une des revendications précédentes, caractérisé en ce que la source de lumière (12) est disposée entre le substrat (11) et la matrice (1) photosensible.

7. Détecteur d'images radiologiques selon l'une des revendications 1 à 5, caractérisé en ce que la source de lumière (12) est formée sur une face (45) du substrat (11) opposée à la matrice (1) photosensible.

8. Détecteur d'images radiologiques selon l'une des revendications 1 à 7, caractérisé en ce que le substrat (11) est transparent à la lumière émise par la source de lumière (12).

9. Détecteur d'images radiologiques, selon la revendication 8, caractérisé en ce que le substrat (11) est en verre.

10. Détecteur d'images radiologiques selon la revendication 6, caractérisé en ce que le substrat (11) est opaque à la lumière émise par la source de lumière (12).

11. Détecteur d'images radiologiques selon la revendication 6, caractérisé en ce que le substrat (11) est métallique.

12. Détecteur d'images radiologiques selon la revendication 6, caractérisé en ce qu'il comporte un écran scintillateur (40) interposé entre le substrat (11) et la source de lumière (12), la source de lumière (12) étant isolée de l'écran scintillateur (40) par une couche isolante (42) en polyimide.

13. Détecteur d'images radiologiques selon la revendication 6, caractérisé en ce que la source de lumière (12) est isolée des éléments photosensibles (D) par une couche isolante en polyimide.

14. Détecteur d'images radiologiques selon la revendication 7, caractérisé en ce que parmi les deux couches électriquement conductrices (13, 20) celle qui est la plus éloignée du substrat (11) est en métal de sorte à constituer un réflecteur.

FIG_1

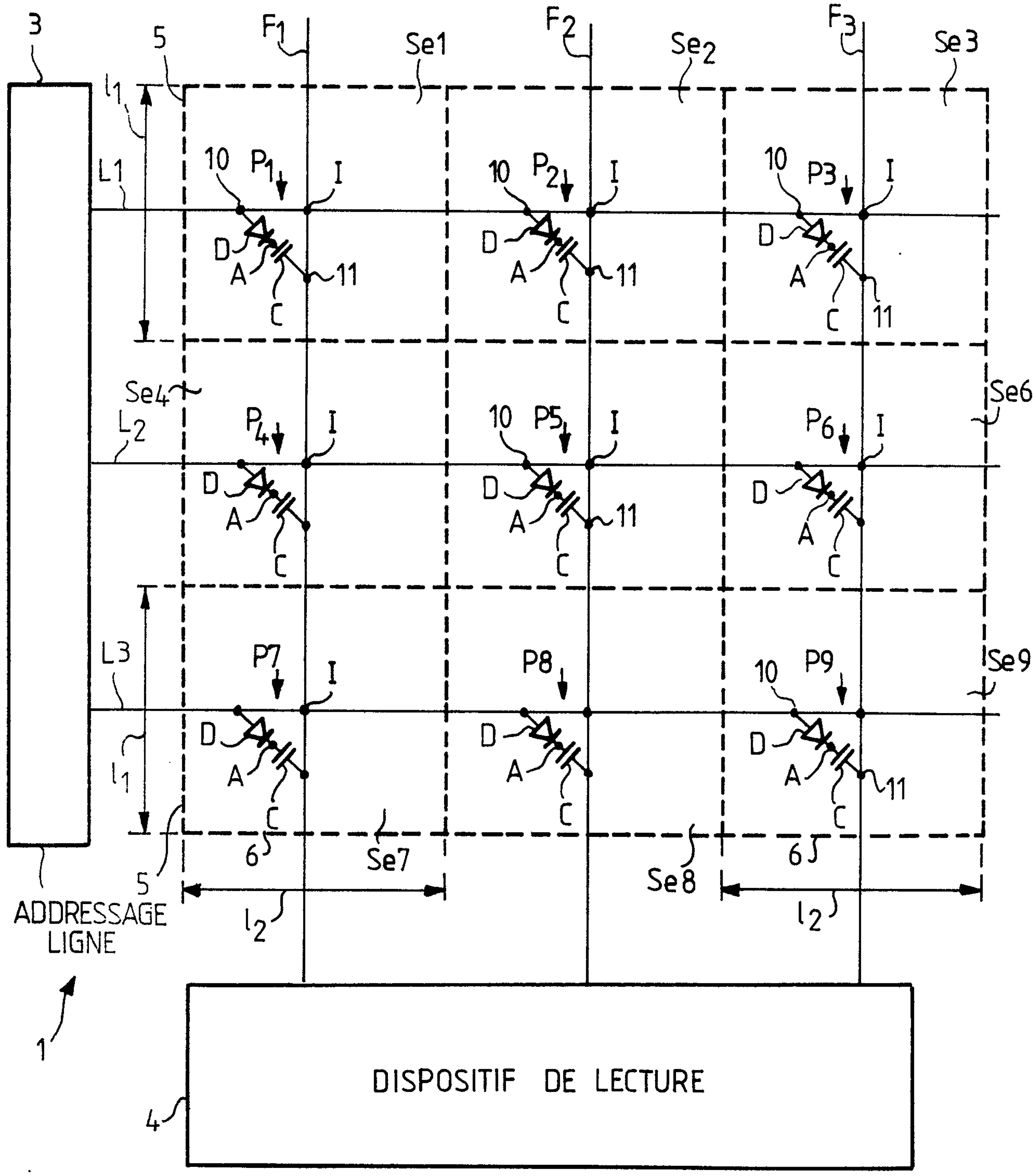
3
5
F1
Se1
F2
Se2
F3
Se3
l1
L1
10
P1
I
P2
P3
D
A
C
11
Se4
Se6
L2
P4
P5
P6
L3
P7
P8
P9
Se9
l1
5
6
Se7
Se8
l2
ADDRESSAGE LIGNE
1
DISPOSITIF DE LECTURE
4

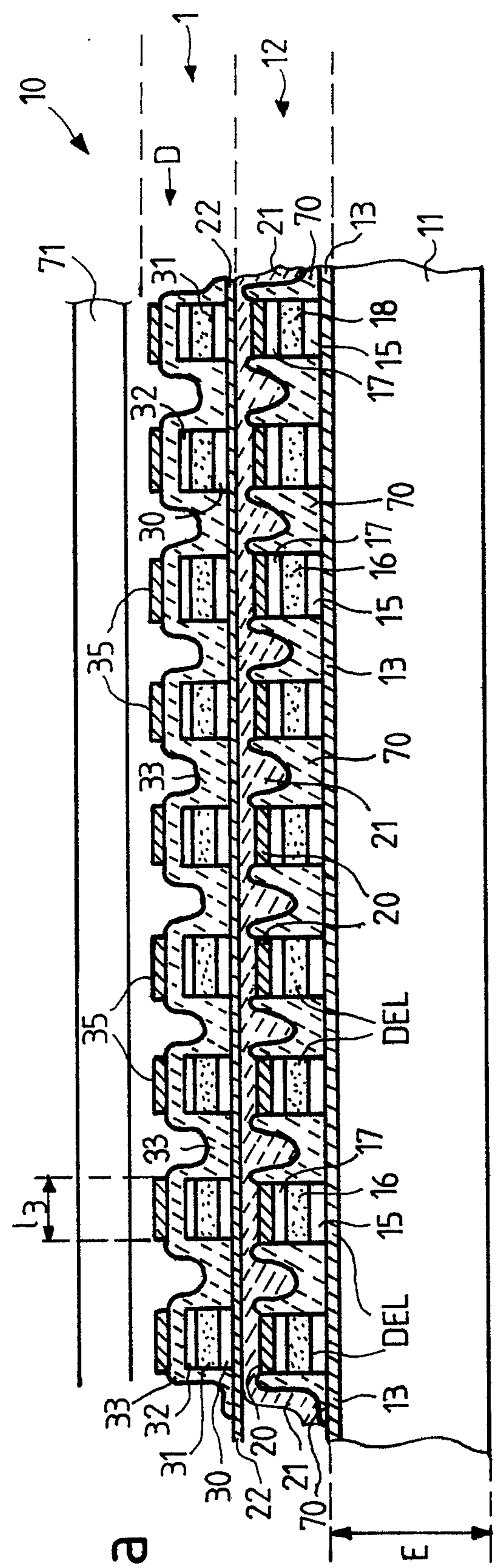
10
1
12
D
71
31
22
21
70
13
11
32
18
17
15
30
16
35
33
20
DEL
l3
E

FIG_2-a

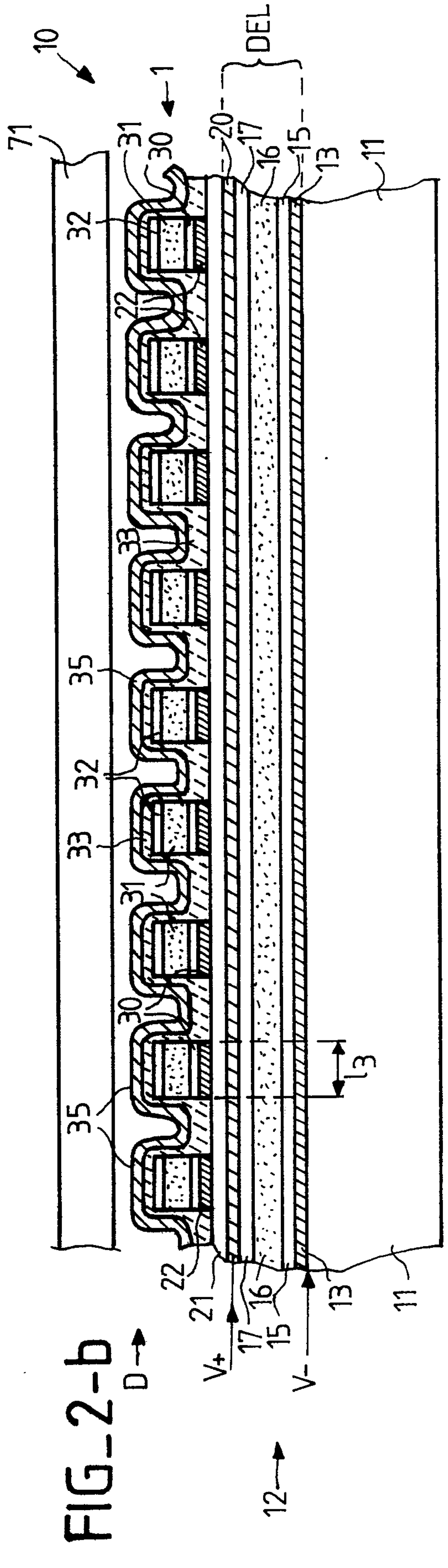
10
1
DEL
71
31
30
20
17
16
15
13
11
32
22
33
35
l3
21
D
V+
V-
12

FIG_2-b

FIG_3

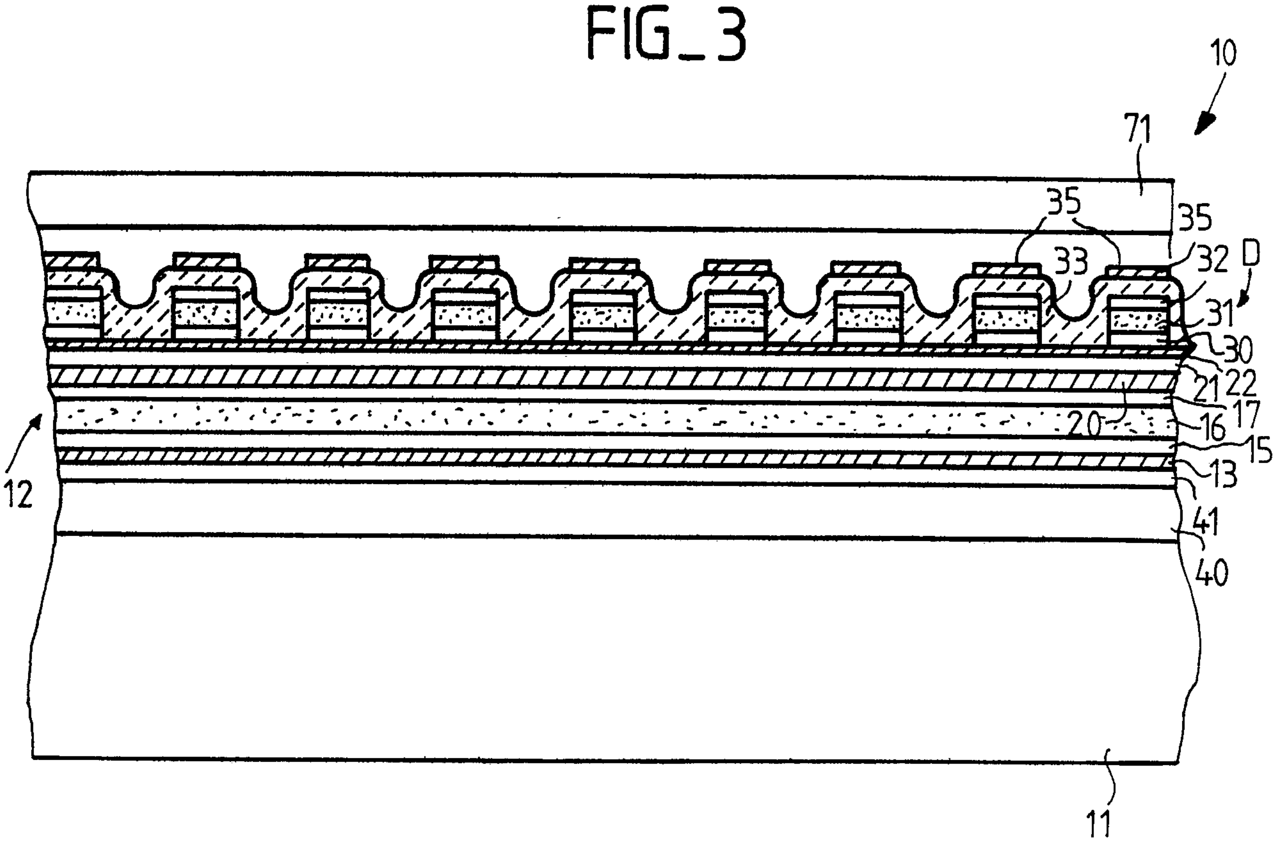
10
71
35
35
33
32
D
31
30
22
21
17
20
16
15
13
41
40
12
11

FIG_4

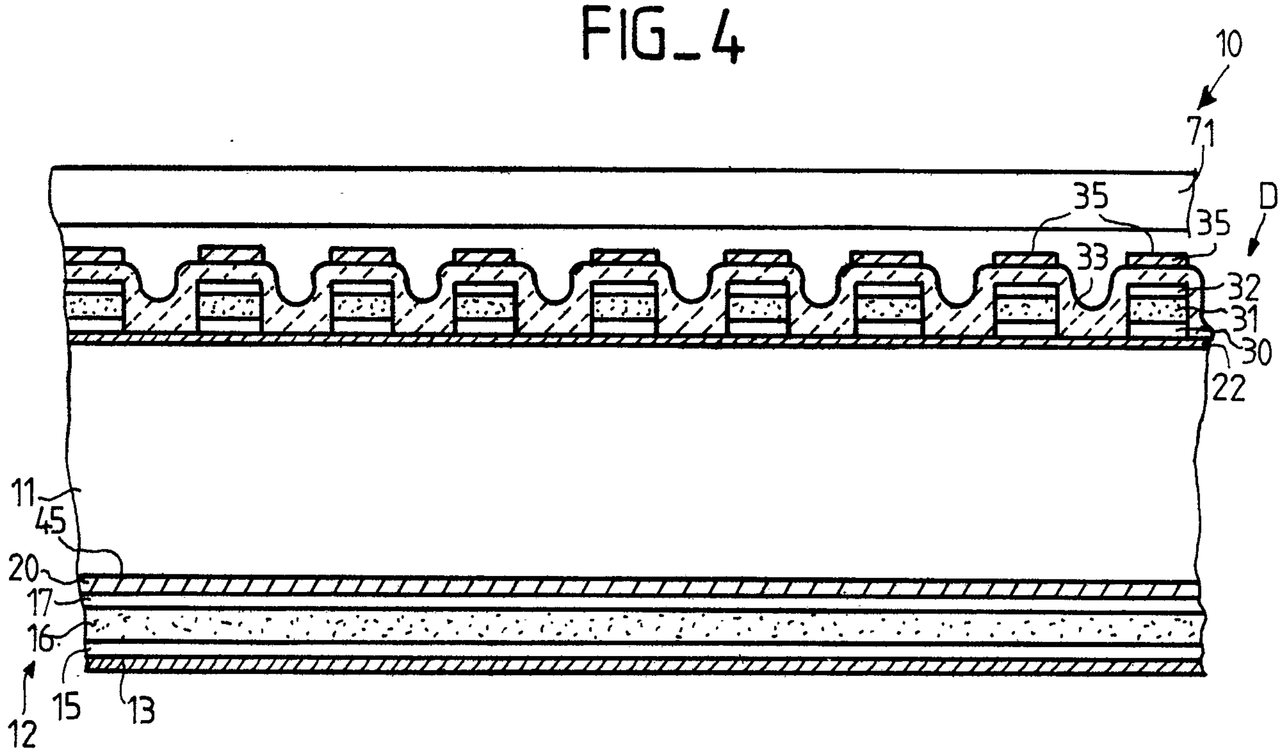
10
71
35
35
D
33
32
31
30
22
11
45
20
17
16
15
13
12

Office européen des brevets

# RAPPORT DE RECHERCHE EUROPEENNE

Numero de la demande

EP 89 40 1128

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 245 147 (THOMSON-CSF)<br>* Colonne 13, ligne 42 - colonne 14, ligne 17; revendications; figures 7,8,13 * | 1,4,7-9 | H 01 L 31/02<br>H 01 L 31/16<br>H 01 L 27/14 |
| D,Y | FR-A-2 593 343 (THOMSON-CSF)<br>* Page 9, ligne 17 - page 11, ligne 10; revendications 1-5,12; figures 5,6 * | 1,8,9 | |
| Y | PATENT ABSTRACTS OF JAPAN, vol. 8, no. 4 (E-220)[1441], 10 janvier 1984, page 55 E 220; & JP-A-58 170 082 (TOKYO SHIBAURA DENKI K.K.) 06-10-1983<br>* Résumé * | 1,8,9 | |
| A | IDEM | 2,3,7 | |
| A | EP-A-0 084 621 (IBM CORP.)<br>* Page 2, ligne 20 - page 4, ligne 21; figures 1,2; revendications 1,4 * | 1,3,4,7,8 | |
| D,A | JAPANESE JOURNAL OF APPLIED PHYSICS, vol. 24, no. 10, octobre 1985, pages L806-L808, Tokyo, JP; D. KRUANGAM et al.: "Visible-light injection-electroluminescent a-SiC/p-i-n diode"<br>* En entier * | 1,2 | **DOMAINES TECHNIQUES RECHERCHES (Int. Cl.4)**<br>H 01 L |
| A | FR-A-1 384 688 (IBM CORP.) | | |
| A | FR-A-1 548 852 (IBM CORP.) | | |

Le présent rapport a été établi pour toutes les revendications

| Lieu de la recherche | Date d'achèvement de la recherche | Examinateur |
|---|---|---|
| LA HAYE | 17-07-1989 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)